# EUROPEAN PATENT SPECIFICATION

(11) **EP 0 817 197 B1**
(45) Date of publication and mention of the grant of the patent: **10.09.2003**
(21) Application number: 97110300.7
(22) Date of filing: 24.06.1997
(51) Int. Cl.: G11C 8/00, G11C 11/408

(54) **Improvements in or relating to integrated circuits**
Verbesserungen betreffend integrierte Schaltungen
Améliorations concernant des circuits intégrés

(30) Priority: 28.06.1996 US 20674 P
(43) Date of publication of application: 07.01.1998
(73) Proprietor: TEXAS INSTRUMENTS INCORPORATED, Dallas Texas 75265 (US)
(72) Inventor: Sukegawa, Shunichi, Tsukuba-shi, Ibaraki 300 (JP); McAdams, Hugh P., McKinney, TX 75070 (US); Tadashi, Tachibana, Tsuchiura-shi, Ibaraki 300 (US); Komatsuzaki, Katsuo, Niihari-gun, Ibaraki 300-41 (NP); Sakai, Takeshi, 3-1120 Kabe-machi, Ohme-shi Tokyo 198 (JP)
(74) Representative: Degwert, Hartmut, Dipl.-Phys.

(56) References cited:
- US-A- 4 827 449

## Description

### FIELD OF THE INVENTION

This invention relates to an integrated circuit and more particularly to an integrated circuit including a wordline strap circuit.

### BACKGROUND OF THE INVENTION

Present complementary metal oxide semiconductor (CMOS) dynamic random access memory (DRAM) circuits are frequently used for main memory in a variety of applications including desk top and portable computer systems. Advances in processor design and software development require dynamic random access memory circuits with high density and fast access time for main memory. A significant part of total access time of a dynamic random access memory circuit is due to wordline transition time from a low voltage to a high voltage. This wordline transition time is limited by a product of resistance and capacitance associated with the wordline.

Previous memory circuits have employed a metal strap or shunt in parallel with a polycrystalline silicon wordline to reduce the total wordline resistance, thereby reducing the total access time of the dynamic random access memory circuit. In FIG. 12A, a wordline strap 1200 is coupled between a row decode AND gate 386 and each of polycrystalline wordline segments 1210-1216. by contacts 1204-1208 to reduce total resistance of the wordline. However, a problem with this method arises when the minimum pitch (metal width plus metal-to-metal space) of the metal wordline strap is greater than the pitch of memory cells of the dynamic random access memory circuit. If the pitch of wordline straps is reduced below the capability of manufacturing equipment, functional yield of the dynamic random access memory circuits is greatly reduced due to shorted metal lines.

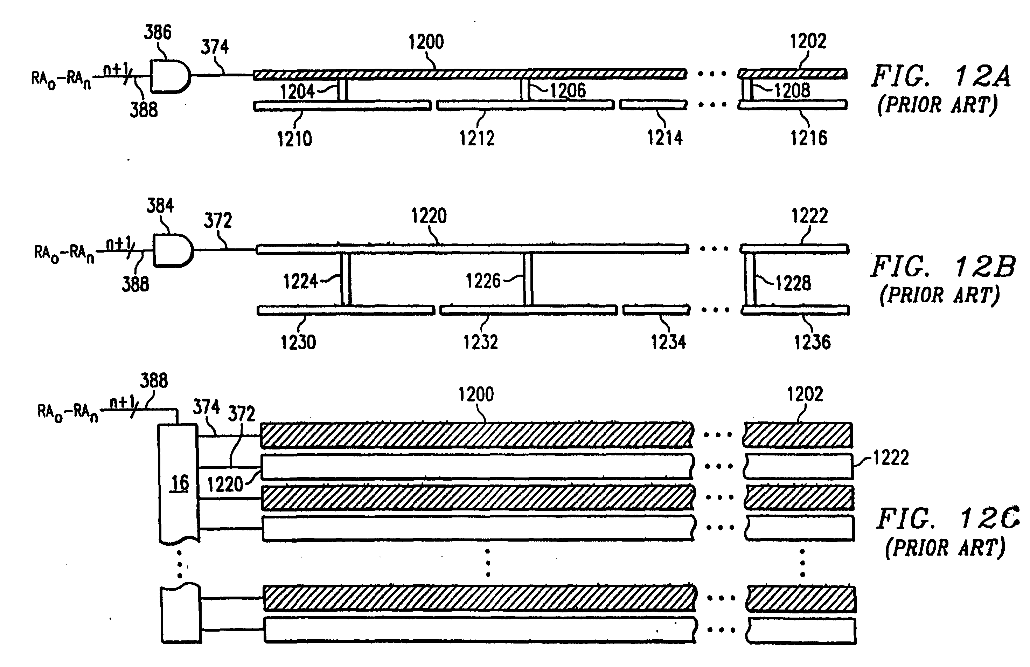

Other dynamic random access memory circuits have employed two-level metal straps to reduce the wordline strap to the pitch of the memory cells. In FIG. 12A, a lower metal conductor 1200 is coupled between a row decode AND gate 386 and each of polycrystalline wordline segments 1210-1216 by contacts 1204-1208 for even wordlines. In FIG. 12B, an upper metal conductor 1220 is coupled between a row decode AND gate 384 and each of polycrystalline wordline segments 1230-1236 by contacts 1224-1228 for odd wordlines. The resulting structure (FIG. 12C) greatly reduces the pitch of the wordline strap without reducing functional yield of the dynamic random access memory circuits. However, another problem arises with this method due to a difference in resistance between the lower and upper metal conductors.

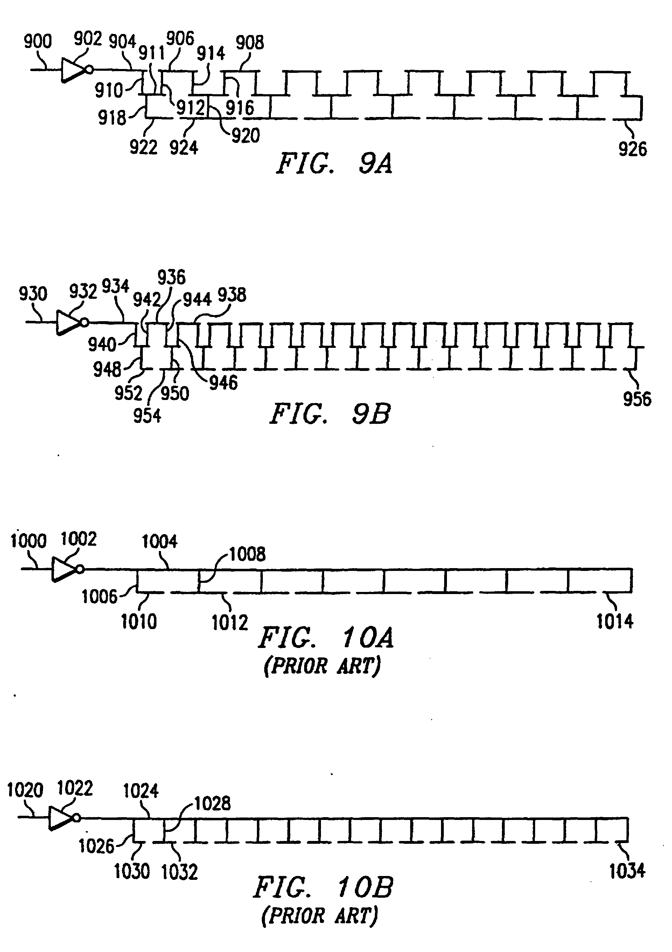

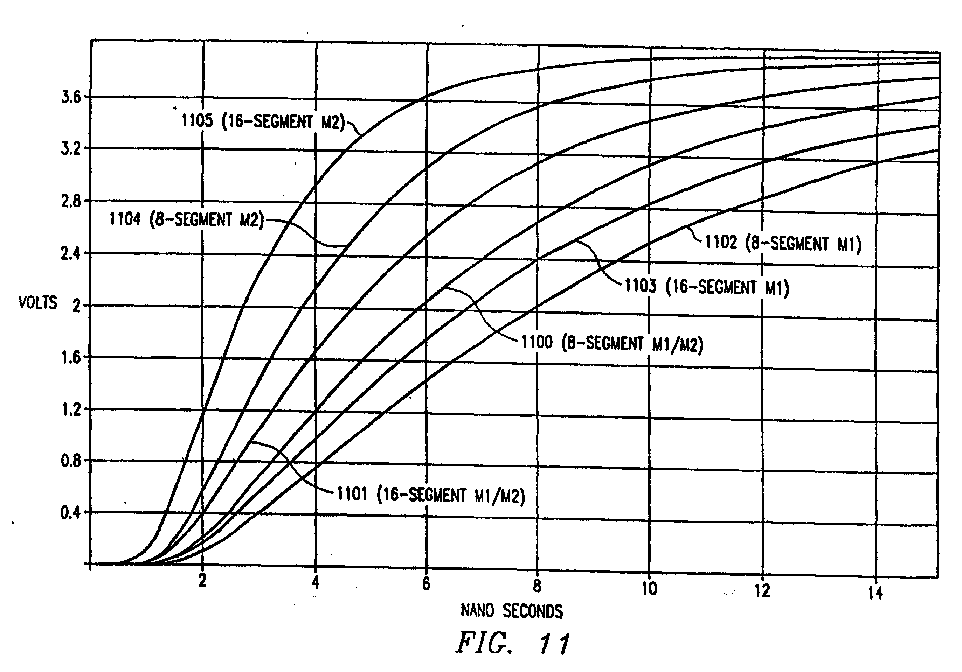

The circuit of FIG. 10A was used to simulate a wordline transition time between inverter 1002 and an end of polycrystalline silicon segment 1014 for two resistance values of wordline strap 1004, representing the resistance of a lower metal conductor and an upper metal conductor, respectively. For a wordline having eight polycrystalline silicon segments 1012, the difference between waveform 1102 for a lower metal conductor and waveform 1104 for an upper metal conductor at 2.8 volts is 6 nanoseconds (FIG. 11). For a wordline 1024 having sixteen polycrystalline silicon segments 1032 (FIG. 10B) and the same number of memory cells, waveforms 1103 and 1105 (FIG. 11), respectively, show that a difference of access times between odd and even wordlines is still 6 nanoseconds. This degrades circuit performance, because peak current required to charge the wordline is determined by wordlines having a low resistance strap while access time of the dynamic random access memory circuit is determined by wordlines having a higher resistance strap.

### SUMMARY OF THE INVENTION

These problems of reducing wordline strap pitch, peak current and access time are resolved by a circuit including a first lower conductor having two ends. One end of the first lower conductor is coupled to a first signal source. A first upper conductor having two ends is spaced apart from the first lower conductor by a distance less than an allowable spacing between adjacent lower conductors. One end of the first upper conductor is coupled to a second signal source. A second upper conductor has two ends. One end of the second upper conductor is coupled to another end of the first lower conductor for receiving a signal from the first signal source. A second lower conductor has two ends. The second lower conductor is spaced apart from the second upper conductor by a distance less than the allowable spacing between adjacent lower conductors. One end of the second lower conductor is coupled to another end of the first upper conductor for receiving a signal from the second signal source.

The present invention further provides a method comprising the steps of claim 8.

A preferred embodiment of the present invention uses lower and upper conductors to shunt a wordline, thereby reducing wordline pitch and transition time. Peak current and wordline delay are substantially equal for odd and even wordlines.

### BRIEF DESCRIPTION OF THE DRAWINGS

A more complete understanding of the invention may be gained by reading the subsequent detailed description with reference to the accompanying drawings wherein:
FIG. 1 is a diagram of a 64 megabit dynamic random access memory having an embodiment of the present invention;
FIG. 2 is a diagram of an 8 megabit array of the 64 megabit dynamic random access memory of FIG. 1;
FIG. 3 is a schematic diagram of an octant of the 8 megabit array of FIG. 2;
FIG. 4 is a schematic diagram showing memory cells and sense amplifiers from the octant of FIG. 3;
FIG. 5A is a diagram of an embodiment of the present invention for even wordlines;
FIG. 5B is a diagram of an embodiment of the present invention for odd wordlines;
FIG. 5C is a diagram of an embodiment of the present invention showing odd and even wordlines;
FIG. 6A is a routing diagram of an embodiment of the present invention;
FIG. 6B is a diagram of an embodiment of a via structure of the present invention;
FIG. 6C is a diagram of another embodiment of a via structure of the present invention;
FIG. 6D is a diagram of yet another embodiment of a via structure of the present invention;
FIG. 7 is a routing diagram of another embodiment of the present invention;
FIG. 8A is a layout diagram of an embodiment of the present invention for a lower conductor;
FIG. 8B is a layout diagram of an embodiment of the present invention for an upper conductor;
FIG. 8C is a layout diagram of an embodiment of the present invention showing lower and upper conductors;
FIG. 9A is a diagram of a circuit for simulating an embodiment of the present invention;
FIG. 9B is a diagram of a circuit for simulating another embodiment of the present invention;
FIG. 10A is a diagram of a circuit of prior art;
FIG. 10B is another diagram of a circuit of prior art;
FIG. 11 is a diagram showing simulation waveforms of embodiments of the present invention and of prior art;
FIG. 12A is a diagram of an embodiment of prior art for even wordlines;
FIG. 12B is a diagram of an embodiment of prior art for odd wordlines; and
FIG. 12C is a diagram of an embodiment of prior art showing odd and even wordlines.

### DETAILED DESCRIPTION OF THE PREFERRED EMBODIMENTS

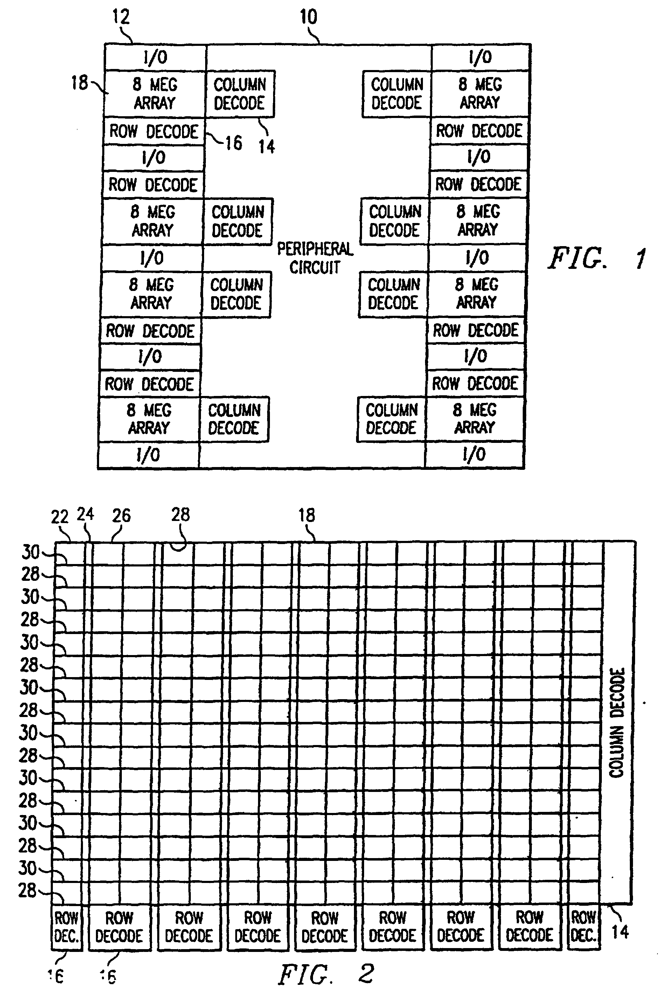

Referring now to FIG. 1, there is a block diagram of a 64 megabit dynamic random access memory circuit. The memory circuit is organized into eight 8 megabit arrays 18 of memory cells. Each 8 megabit array has a column decode circuit 14 and a row decode circuit 16 for selecting plural memory cells from the 8 megabit array. An input-output (I/O) circuit 12 conducts data between the plural memory cells and output terminals (not shown) within a peripheral circuit 10.

An expanded view of the 8 megabit array 18, and column 14 and row 16 decode circuits is shown in FIG. 2. The 8 megabit array is further divided into eight 1 megabit memory banks. Each 1 megabit memory bank includes a sense amplifier bank 24 and left 22 and right 26 memory arrays. Wordlines (not shown) extend parallel to sense amplifier banks 24 from row decode circuits 16 through left 22 and right 26 memory arrays. Each row decode circuit 16 is a signal source for a wordline that selectively activates a respective row of more than 8192 memory cells, including redundant memory cells (not shown), within the left 22 or right 26 memory arrays. It is highly advantageous to reduce signal delay time from the row decode circuit 16, along the respective wordline to the more than 8192 memory cells, thereby reducing time required to read data from or write data to selectively activated memory cells. Thus, wordlines are periodically strapped or shunted as indicated at 28 and 30 with metal conductors to reduce wordline resistance, thereby reducing the product of wordline resistance and capacitance. This reduction of wordline resistance and capacitance greatly reduces signal delay along the respective wordline and resulting data access time of the 64 megabit dynamic random access memory.

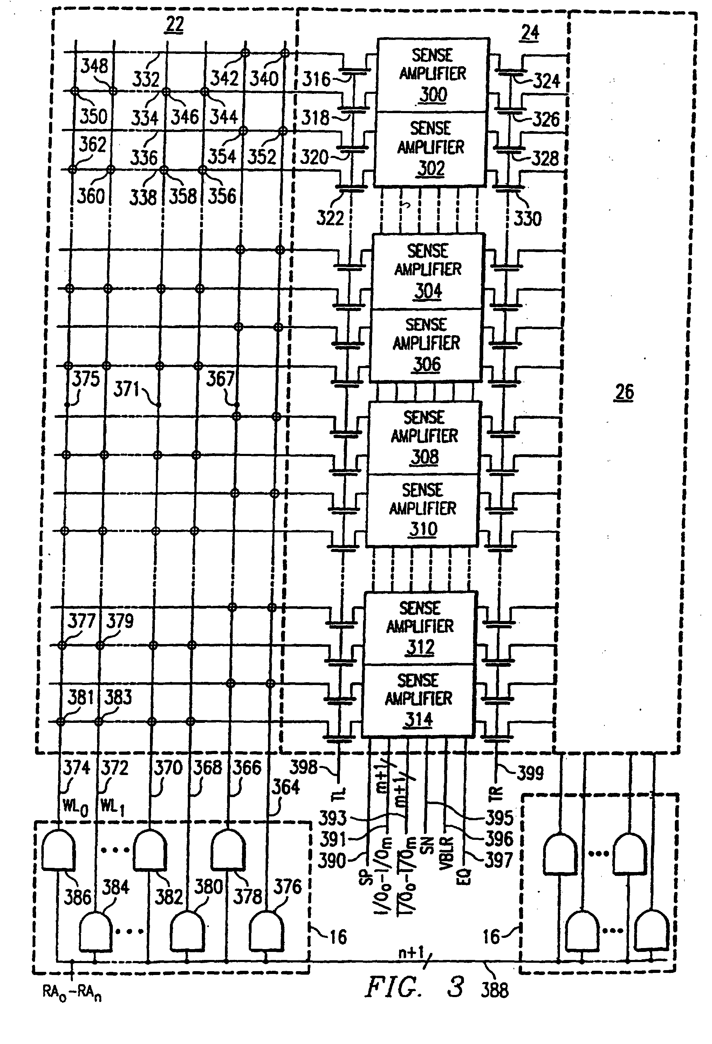

Referring now to FIG. 3, there is a schematic diagram of sense amplifier bank 24 and left 22 and right 26 memory arrays. Row decode circuits 16 include AND gates 376-386 that are responsive to row address signals RA₀-RAₙ at bus 388 for activating a selected wordline. These row address signals RA₀-RAₙ may be predecoded minterms or maxterms of external row address signals as is well known in the art. Each of AND gates 384 and 386, for example, correspond to wordlines 372 and 374, respectively. Memory cells 348 and 350, at the extreme ends of wordlines WL₁ 372 and WL₀ 374, respectively, experience a greater signal delay than other memory cells closer to the row decode circuits 16. Even wordline WL₀ 374 is strapped at multiple locations 28 (FIG. 2) and odd wordline WL₁ 372 is strapped at multiple locations 30 to reduce wordline resistance. Wordline strap location 28 has a contact 375 (FIG. 3) for coupling a lower metal conductor of wordline WL₀ 374 to a polycrystalline silicon gate for memory cells 350 and 362. Corresponding contacts (not shown) for WL₁ 372 are at multiple locations 30.

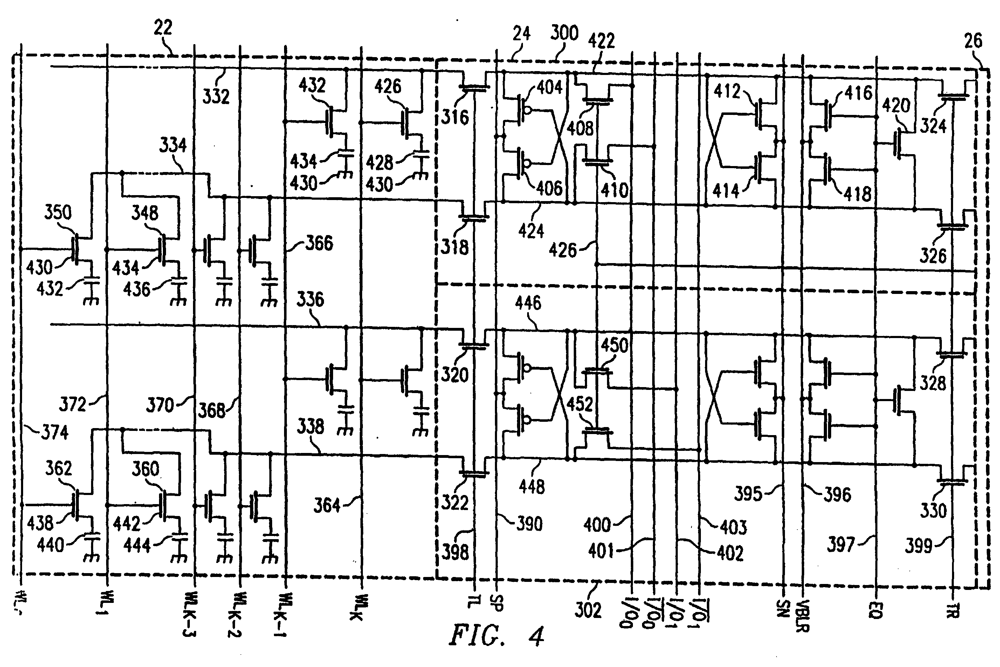

Referring now to FIG. 4, there is a schematic diagram of sense amplifiers 300 and 302 and their respective memory cells. During a read cycle, wordline WL₀ 374, for example, is activated by a selection signal from AND gate 386 (FIG. 3). Memory cell 350 (FIG. 4), including transistor 430 and capacitor 432, is only selected after a time required for the selection signal to propagate to the extreme end of wordline WL₀ 374. Thus, the propagation delay along wordline WL₀ 374 directly increases time required to activate a memory cell 350 in a read cycle. It is therefore highly advantageous to minimize this propagation delay by strapping or shunting wordlines according to the instant invention to reduce memory access time.

After wordline WL₀ 374 selects memory cell 350, transistor 430 conducts and couples a datum from capacitor 432 to bit line 334. The datum is coupled to sense amplifier 300 by transistor 318. A difference voltage between terminals 422 and 424, indicative of the datum, is amplified by sense amplifier 300. In a like manner, transistor 438 conducts, responsive to WL₀ 374, and couples another datum from capacitor 440 to terminal 448 for amplification by sense amplifier 302. Column decode circuit 14 (FIG. 2) selectively produces a column select signal at terminal 426, responsive to column address signals (not shown), for coupling the data from sense amplifiers 300 and 302 (FIG. 4) to complementary data lines I/O₀ 400, and I/O₀ 401, I/O₁ 402 and I/OX₁ 403, respectively. The data is subsequently coupled to I/O circuit 12 (FIG. 1) and, eventually, to other circuits external to the dynamic random access memory.

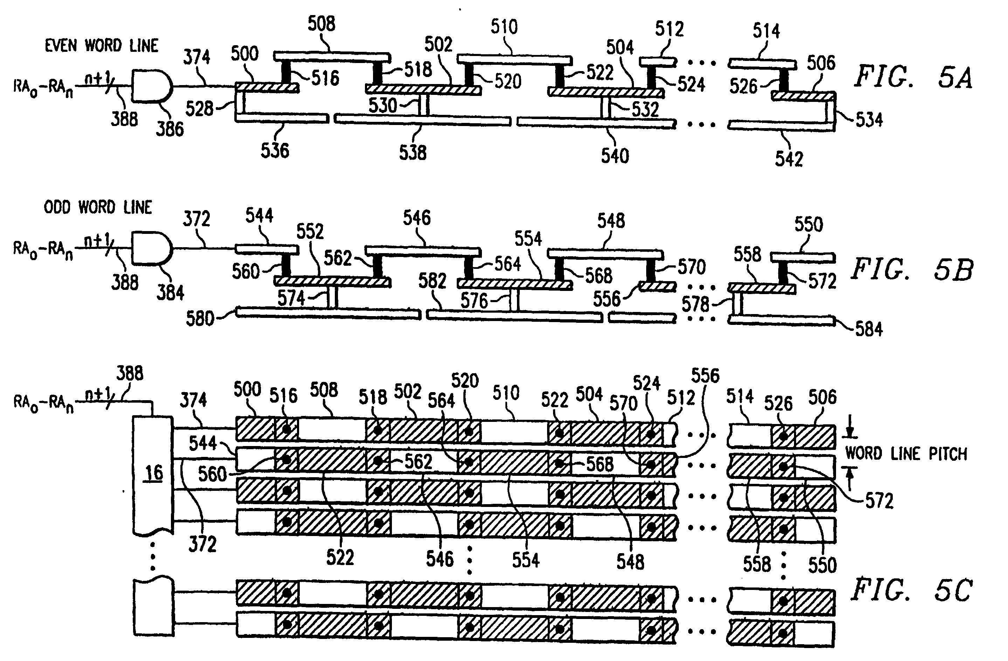

Referring now to FIG. 5A, there is a diagram of an even wordline such as, for example, WL₀ 374 corresponding to a row of memory cells according to an embodiment of the instant invention. Row decode source AND gate 386 is coupled to lower metal conductor 500 which is coupled to polycrystalline silicon wordline half segment 536 through contact 528. Polycrystalline silicon wordline half segment 536 forms a gate for memory cells in the respective row including memory cells 377 and 381 (FIG. 3). Lower metal conductor 500 (FIG. 5A) is further coupled to lower metal conductor 502 through upper metal conductor 508 and vias 516 and 518, respectively. Lower metal conductor 502 is coupled to polycrystalline silicon wordline segment 538 through contact 530. Polycrystalline silicon wordline segment 538 forms a gate for other memory cells in the respective row. This pattern is repeated to polycrystalline silicon wordline half segment 542 the extreme end of WL₀ 374, which forms a gate for memory cells in the respective row including memory cells 350 and 362 (FIG. 3), respectively.

Referring now to FIG. 5B, there is a diagram of an odd wordline such as, for example, WL₁ 372 corresponding to a row of memory cells according to an embodiment of the instant invention. Row decode AND gate 384 is coupled to upper metal conductor 544 which is coupled to lower metal conductor 552 through via 560. Lower metal conductor 552 is coupled to polycrystalline silicon wordline segment 580 through contact 574. Polycrystalline silicon wordline segment 580 forms a gate for memory cells in the respective row including memory cells 379 and 383 (FIG. 3). This pattern is repeated to polycrystalline silicon wordline segment 584 (FIG. 5B) at the extreme end of wordline WL₁ 372, which forms a gate for memory cells in the respective row including memory cells 348 and 360 (FIG. 3), respectively.

Referring now to FIG. 5C, there is a diagram of a top view of even and odd wordline straps as in FIG. 5A and FIG. 5B, respectively. Even wordline strap WL₀ 374, for example, includes two lower metal conductor half segments 500 and 506 at either end, fifteen lower metal conductor segments 502-504 and sixteen upper metal conductor segments 508-514 connected in series. In a similar manner odd wordline strap WL₁ 372, for example, includes two upper metal conductor half segments 544 and 550 at either end, fifteen upper metal conductor segments 546-548 and sixteen lower metal conductor segments 552-558 connected in series. This arrangement is highly advantageous for several reasons. First, the total resistance of both odd and even wordline straps is the same even if the resistance of lower metal conductor segments is substantially greater than the resistance of upper metal conductor segments. Thus, access time for memory cells on odd and even rows is the same. Second, it is possible to contact polycrystalline silicon segments on both odd and even wordlines from lower metal conductors only. This avoids the need to make contacts directly from an upper metal conductor directly to a polycrystalline silicon segments, a step that may be less reliable due to a greater aspect ratio (depth to diameter) of the contact. Finally, for a substantial part of the length of a wordline strap, the adjacent wordline strap is formed of a different metal conductor. Close spacing between like metal conductors only occurs at relatively smaller overlap regions where vias, for example vias 516 and 560, are formed. Thus, the probability of shorting adjacent wordline straps during fabrication is greatly reduced. Moreover, wordline strap pitch (the distance between center lines) may be less than a minimum allowable pitch for metal lines formed of the same metal without a corresponding decrease in reliability. This minimum allowable pitch includes a minimum allowable width and a minimum allowable space for like metal lines, below which reliability of the manufacturing process is compromised by an increased probability of shorted or open metal lines. Such minimum allowable feature sizes are characterized by a substantial occurrence on a 64 megabit dynamic random access memory or other device.

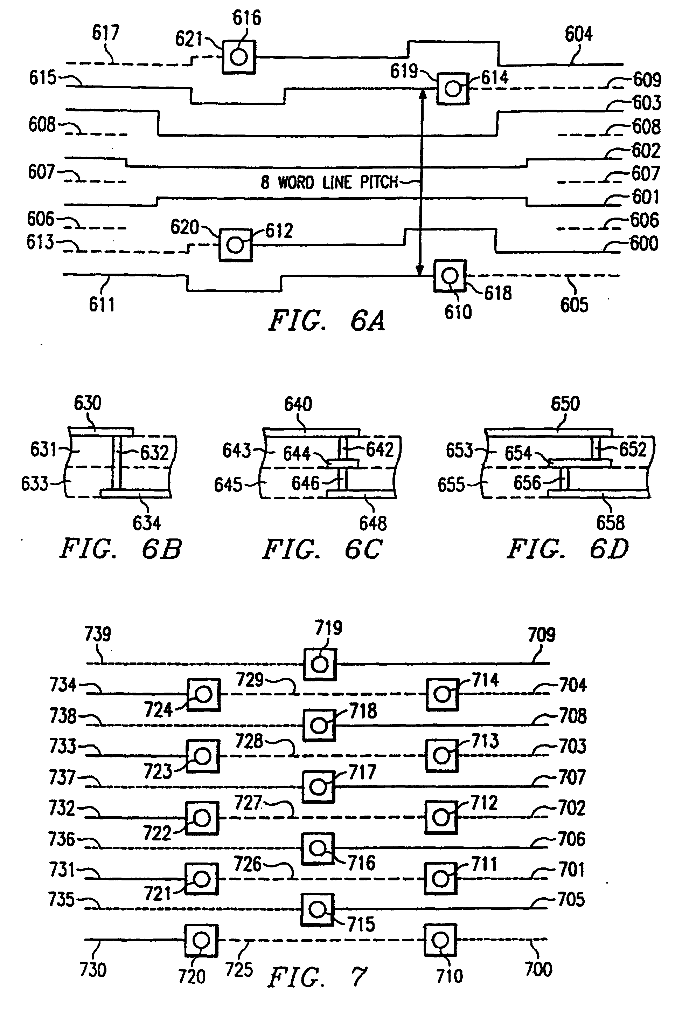

Referring now to FIG. 6A, there is a diagram showing a routing technique that obviates the need for close spacing between like metal conductors at, for example vias 516 and 560 (FIG. 5C). Here, upper metal conductor 605 and lower metal conductor 611 are connected by via 610 at overlap region 618 (FIG. 6A). Adjacent lower metal conductor 600 and upper metal conductor 613 are connected by via 612 at overlap region 620. Connection points for the next six wordline straps 601-603 and 606-608 are displaced with respect to connection points for wordline straps 600 and 605. The pattern of eight wordline straps is repeated with wordline straps 604 and 609, which correspond to wordline straps 600 and 605, respectively. For example, a minimum 8 wordline strap pitch includes the width of one via (0.36µm), two lower metal conductor overlaps of the via (2*0.15 µm), four lower metal conductor widths (4*0.3 µm) and five spaces between lower metal conductors (5*0.3 µm) for a total of 3.36 µm. Thus, a single wordline pitch according to the instant invention may be 3.36/8 µm or 0.42 µm. This is substantially less than a comparable minimum wordline strap pitch (0.3 µm width plus 0.3 µm space) for a single metal conductor. Alternatively, if a single wordline pitch is greater than 0.42 µm but less than 0.6 µm, spacing between like metal conductors may be appropriately increased to improve reliability.

In a similar manner, a wordline pitch may be further reduced by repeating a wordline crossover pattern every 16 wordlines. A minimum 16 wordline strap pitch includes the'width of one via (0.36 µm), two lower metal conductor overlaps of the via (2*0.15 µm), eight lower metal conductor widths (8*0.3 µm) and nine spaces between lower metal conductors (9*0.3 µm) for a total of 5.76 µm. Thus, a single wordline pitch may be further reduced to 5.76/16 µm or 0.36 µm.

The total length of a region required for displaced connection points is typically less than twenty percent of the length of a metal conductor segment. Thus, adjacent lower and upper metal conductor segments, for example 600 and 605, are substantially equal in length. Overlap regions 618 and 620 are spaced apart and adjacent like metal conductors 600 and 611, respectively, are offset to maintain at least a desired minimum space between like metal conductors even if the wordline strap pitch is less than an allowable pitch for either upper or lower like metal conductors. This significantly improves the reliability of metal interconnection during fabrication by permitting like metal conductors to be spaced apart a distance greater than a minimum allowable spacing for like metal conductors even if the wordline pitch is less than the minimum allowable spacing for like metal conductors. Moreover, displacement of connection points between upper and lower metal conductors with respect to other connection points takes place over memory cell arrays, for example 22 and 26 (FIG. 2), so no additional layout area is required.

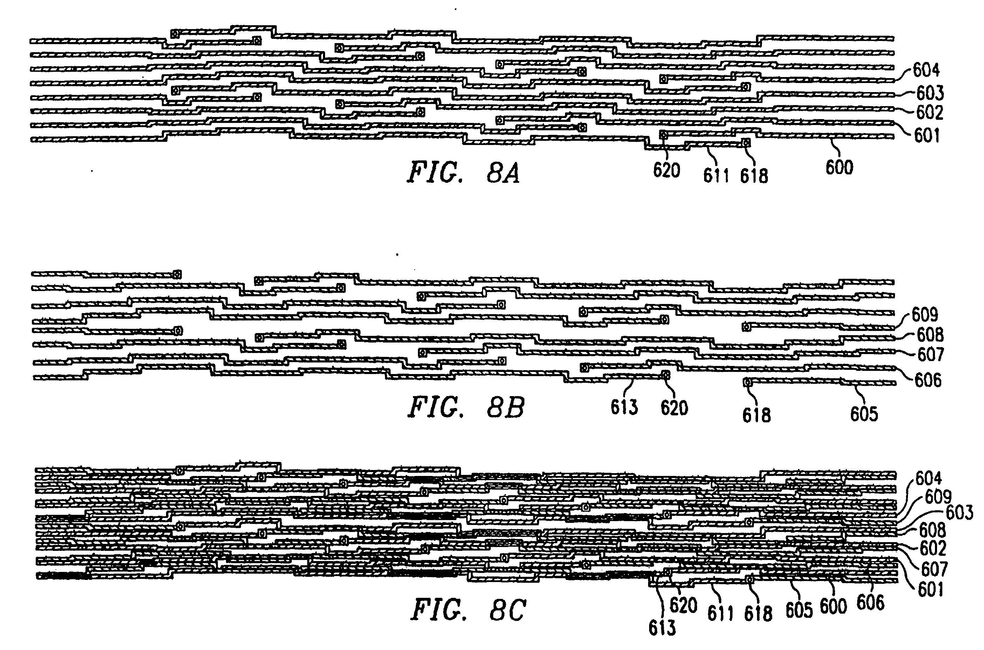

Referring now to FIG. 8A, there is a diagram showing an actual layout of a lower metal conducting layer corresponding to the diagram of FIG. 6A. The diagram of FIG. 8B shows an actual layout of an upper metal conducting layer corresponding to the diagram of FIG. 6A. Finally, the diagram of FIG. 8C shows a layout of the combined lower and upper metal conducting layers of FIG. 8A and FIG. 8B, respectively, having corresponding numerals throughout.

Referring now to FIG. 9A and 9B, there are diagrams of circuits, including parasitic resistance and capacitance of interconnection segments and memory cell capacitance (not shown), used for simulating embodiments of the instant invention. The circuit of FIG. 9A is a model of a wordline having eight upper metal conductors. The circuit of FIG. 9B is a model of a wordline having sixteen upper metal conductors. Each wordline further includes a corresponding number of lower metal conductors and polycrystalline silicon segments, but each wordline has the same total number of memory cells. Here, inverter 902 (FIG. 9A) and inverter 932 (FIG. 9B) are signal sources corresponding to a row decode circuit, for example AND gate 386 (FIG. 5A).

Simulation results for the circuit of FIG. 9A and FIG. 9B are shown in FIG. 11. The simulation begins when signals at input terminals 900 and 930 of inverters 902 and 932, respectively, make simultaneous transitions from a logical high level to a logical low level at a starting time of zero. Waveforms 1100 and 1101 represent a resulting voltage at the extreme end of polycrystalline segments 926 and 956, respectively. Waveform 1101 compared to waveform 1100 shows that the circuit of FIG. 9B, having sixteen segments, offers an advantage of 1.5 nanoseconds at 2.8 volts over the circuit of FIG. 9A. Moreover, a comparison of waveforms 1101 and 1100 to waveforms 1103 and 1102, respectively, shows that each of the circuits of FIG. 9A and FIG. 9B offers an advantage of 3 nanoseconds at 2.8 volts over a more resistive single metal conductor of prior art in FIG. 12C. For a dynamic random access memory having, for example, a 50 nanosecond access time (tRAC), this represents an improvement of six percent. Thus, significant improvements in reliability and access time accrue from these embodiments of the instant invention.

Although embodiments of the invention have been described in detail with reference to preferred embodiments, it is to be understood that the foregoing description is by way of example only and is not to be construed in a limiting sense. For example, upper and lower metal conductor segments may be connected according to the routing diagram of FIG. 7 where three conducting layers are available. A connection point for one wordline strap has a first metal conductor segment 709 connected to third metal conductor segment 739 at via 719. An adjacent wordline strap has two connection points at vias 724 and 714, respectively. A first metal conductor segment 734 is connected to a second metal conductor segment 729 at via 724. The second metal conductor segment 729 is connected to a third metal conductor segment 704 at via 714. Direct connection between first 634 and third 630 metal conductor segments (FIG. 6B) may be realized by standard etch techniques through first 633 and second 631 insulating layers and subsequent deposition of a conformal metal such as tungsten or other conductive material to form via 632. In another embodiment, first 648 and third 640 metal conductor segments are connected through a second metal conductor segment 644 by patterning one via 642 directly above another via 646 (FIG. 6C). In another embodiment, first 658 and third 650 metal conductor segments may connected through a second metal conductor segment 654 by displacing one via 652 with respect to another via 656 (FIG. 6D). In yet another embodiment, the instant invention may be used for any interconnection application to reduce layout area by reducing the pitch of adjacent conductors while improving reliability by maintaining at least a minimum allowable spacing between adjacent like metal conductors. This embodiment of the instant invention is realized by omission of contacts and polycrystalline wordline segments (FIG. 5A and FIG. 5B). Such applications include wide data and address bus circuits for memory and microprocessor devices.

It is to be further understood that numerous changes in the details of the embodiments of the invention will be apparent to persons of ordinary skill in the art having reference to this description. It is contemplated that such changes and additional embodiments are within the scope of the invention.

## Claims

1. A circuit comprising:
a first lower conductor (500) having two ends, one end of the first lower conductor (500) being coupled to a first signal source (386);
a first upper conductor (544) having two ends, the first upper conductor (544) being spaced apart from the first lower conductor (500) by a distance less than an allowable spacing between adjacent lower conductors, one end of the first upper conductor (544) being coupled to a second signal source (384); a second upper conductor (508) having two ends, one end of the second upper conductor (508) being coupled to another end of the first lower conductor (500) for receiving a signal from the first signal source (386); and
a second lower conductor (552) having two ends, the second lower conductor (522) being spaced apart from the second upper conductor (508) by a distance less than the allowable spacing between adjacent lower conductors, one end of the second lower conductor (522) being coupled to another end of the first upper conductor (544) for receiving a signal from the second signal source (384).

2. A circuit as in claim 1, wherein the first lower conductor (500) is separated from the second upper conductor (508) and the first upper conductor (544) is separated from the second lower conductor (552) by an insulating layer.

3. A circuit as in claim 1 or claim 2, further comprising a third conductor (536) coupled to the first lower conductor (500) and a fourth conductor (580) coupled to the second lower conductor (522).

4. A circuit as in claim 3, wherein each of the third and fourth conductors (536, 580) are connected to a plurality of memory cells (340, 342, 344, 346), each memory cell comprising at least one MOS transistor (426), the MOS transistor having a gate connected to one of the respective third and fourth conductors.

5. A circuit as in claim 3 or claim 4, wherein the third and fourth conductors (536, 580) comprise polycrystalline silicon word lines, the polycrystalline silicon word lines having a pitch less than the allowable spacing between adjacent lower conductors.

6. A circuit as in any of claims 1 to 5, wherein the first lower conductor (500) and the first upper conductor (544) are parallel to each other for a substantial part of the length of the first upper conductor (544), and the second upper conductor (508) and the second lower conductor (552) are parallel to each other for a substantial part of the length of the second upper conductor (552).

7. A circuit as in any of claims 1 to 6, wherein the first lower conductor (500) is coupled to the second upper conductor (508) by a fifth conductor (516) and the first upper conductor (544) is coupled to the second lower conductor (552) by a sixth conductor (560), the fifth and sixth conductors having different material properties than the first and second upper conductors.

8. A method of forming a wiring circuit comprising the steps of
forming a first plurality of lower wiring segments (500, 502, 504) in a substantially linear orientation;
forming a second plurality of lower wiring segments (552, 554, 556) in a substantially linear orientation;
forming a first plurality of upper wiring segments (508, 510), spaced apart from said first lower wiring segments by a distance less than an allowable spacing between said first and second lower wirings, in a substantially linear orientation, thereby electrically connecting the first plurality of lower wiring segments; and
forming a second plurality of upper wiring segments (546, 548) in a substantially linear orientation, thereby electrically connecting the second plurality of lower wiring segments.

9. A method as in claim 8 comprising the steps of:
forming the first plurality of lower wiring segments (500, 502, 504) adjacent the first plurality of upper wiring segments (508, 510); and
forming the second plurality of lower wiring segments (552, 554, 556) adjacent the second plurality of upper wiring segments (546, 548).

10. A method as in claim 8 or claim 9 comprising the steps of:
forming a first plurality of word line segments (536, 538, 540) connected to respective segments of the first plurality of lower wiring segments (500, 502, 504); and
forming a second plurality of word line segments (580, 582, 584) connected to respective segments of the second plurality of lower wiring segments (552, 554, 556).

## Patentansprüche

1. Ein Schaltkreis, der folgendes umfaßt:
einen ersten unteren Leiter (500) mit zwei Enden, wobei ein Ende des ersten unteren Leiters (500) mit einer ersten Signalquelle (386) verbunden ist;
einen ersten oberen Leiter (544) mit zwei Enden, wobei der erste obere Leiter (544) vom ersten unteren Leiter (500) in einem Abstand angeordnet ist, der geringer ist als der zulässige Abstand zwischen benachbarten unteren Leitern, wobei ein Ende des ersten oberen Leiters (544) mit einer zweiten Signalquelle (384) verbunden ist;
einen zweiten oberen Leiter (508) mit zwei Enden, wobei ein Ende des zweiten oberen Leiters (508) mit einem anderen Ende des ersten unteren Leiters (500) verbunden ist, um ein Signal von der ersten Signalquelle (386) zu empfangen; und
einen zweiten unteren Leiter (552) mit zwei Enden, wobei der zweite untere Leiter (522) vom zweiten oberen Leiter (508) in einem Abstand angeordnet ist, der geringer ist als der zulässige Abstand zwischen benachbarten unteren Leitern, wobei ein Ende des zweiten unteren Leiters (522) mit einem anderen Ende des ersten oberen Leiters (544) verbunden ist, um von der zweiten Signalquelle (384) ein Signal zu empfangen.

2. Ein Schaltkreis nach Anspruch 1, worin der erste untere Leiter (500) vom zweiten oberen Leiter (508) durch eine isolierende Schicht getrennt ist und der erste obere Leiter (544) von dem zweiten unteren Leiter (552) durch eine isolierende Schicht getrennt ist.

3. Ein Schaltkreis nach Anspruch 1 oder Anspruch 2, der weiterhin enthält einen dritten Leiter (536), der mit dem ersten unteren Leiter (500) verbunden ist und einen vierten Leiter (580), der mit dem zweiten unteren Leiter (522) verbunden ist.

4. Ein Schaltkreis nach Anspruch 3, worin der dritte und der vierte Leiter (536, 580) mit einer Mehrzahl von Speicherzellen (340, 342, 344, 346) verbunden ist, wobei jede Speicherzelle mindestens einen MOS-Transistor (426) enthält, wobei der MOS-Transistor ein Gate hat, das mit dem entsprechenden dritten bzw. vierten Leiter verbunden ist.

5. Ein Schaltkreis nach Anspruch 3 oder Anspruch 4, wobei der dritte und der vierte Leiter (536, 580) Wortleitungen aus polykristallinem Silizium einschließen, wobei die Wortleitungen aus polykristallinem Silizium ein Rastermaß haben, das geringer ist als der zulässige Abstand zwischen benachbarten unteren Leitern.

6. Ein Schaltkreis nach einem der Ansprüche 1 bis 5, worin der erste untere Leiter (500) und der erste obere Leiter (544) entlang eines wesentlichen Teils der Länge des ersten oberen Leiters (544) parallel zueinander sind, und der zweite obere Leiter (508) und der zweite untere Leiter (552) über einen wesentlichen Teil der Länge des zweiten oberen Leiters (552) parallel zueinander sind.

7. Ein Schaltkreis nach einem der Ansprüche 1 bis 6, worin der erste untere Leiter (500) mit dem zweiten oberen Leiter (508) über einen fünften Leiter (516) verbunden ist und der erste obere Leiter (544) mit dem zweiten unteren Leiter (552) über einen sechsten Leiter (560) verbunden ist, wobei der fünfte und der sechste Leiter andere Materialeigenschaften haben als der erste und der zweite obere Leiter.

8. Ein Verfahren zur Bildung eines Verdrahtungsschaltkreises, das folgende Schritte umfaßt:
Bildung einer ersten Mehrzahl von unteren Verdrahtungssegmenten (500, 502, 504) in einer im wesentlichen linearen Orientierung;
Bildung einer zweiten Mehrzahl von unteren Verdrahtungssegmenten (552, 554, 556) in einer im wesentlichen linearen Orientierung;
Bildung einer ersten Mehrzahl von oberen Verdrahtungssegmenten (508, 510), die von den ersten unteren Verdrahtungssegmenten in einem Abstand angeordnet sind, der geringer ist als der zulässige Abstand zwischen den ersten und zweiten unteren Verdrahtungen, in einer im wesentlichen linearen Orientierung, dadurch die erste Mehrzahl von unteren Verdrahtungssegmenten elektrisch verbindend; und
Bildung einer zweiten Mehrzahl von oberen Verdrahtungssegmenten (546, 548) in einer im wesentlichen linearen Orientierung, dadurch die zweite Mehrzahl von unteren Verdrahtungssegmenten elektrisch verbindend.

9. Ein Verfahren nach Anspruch 8, das die folgenden Schritte enthält:
Bildung der ersten Mehrzahl von unteren Verdrahtungssegmenten (500, 502, 504) benachbart zu der ersten Mehrzahl von oberen Verdrahtungssegmenten (508, 510); und
Bildung der zweiten Mehrzahl von unteren Verdrahtungssegmenten (552, 554, 556) benachbart zu der zweiten Mehrzahl von oberen Verdrahtungssegmenten (546, 548).

10. Ein Verfahren nach Anspruch 8 oder Anspruch 9, das die folgenden Schritte umfaßt:
Bildung einer ersten Mehrzahl von Wortleitungssegmenten (536, 538, 540), die mit entsprechenden Segmenten der ersten Mehrzahl von unteren Verdrahtungssegmenten (500, 502, 504) verbunden sind; und
Bildung einer zweiten Mehrzahl von Wortleitungssegmenten (580, 582, 584), die mit entsprechenden Segmenten der zweiten Mehrzahl von unteren Verdrahtungssegmenten (552, 554, 556) verbunden sind.

## Revendications

1. Circuit comprenant :
un premier conducteur inférieur (500) possédant deux extrémités, une extrémité du premier conducteur inférieur (500) étant couplée à une première source de signaux (386);
un premier conducteur supérieur (544) comportant deux extrémités, le premier conducteur supérieur (544) étant séparé du premier conducteur inférieur (500) par une distance inférieure à un espacement admissible entre des conducteurs inférieurs adjacents, une extrémité du premier conducteur supérieur (544) étant couplée à une seconde source de signaux (384);
un second conducteur supérieur (508) possédant deux extrémités, une extrémité du second conducteur supérieur (508) étant couplée à une autre extrémité du premier conducteur inférieur (500) pour recevoir un signal de la part de la première source de signaux (386); et
un second conducteur inférieur (552) comportant deux extrémités, le second conducteur inférieur (552) étant séparé du premier conducteur supérieur (508) par une distance inférieure à l'espacement admissible entre deux conducteurs inférieurs adjacents, une extrémité du second conducteur inférieur (522) étant couplée à une autre extrémité du premier conducteur supérieur (544) pour recevoir un signal provenant de la seconde source de signaux (384).

2. Circuit selon la revendication 1, dans lequel le premier conducteur inférieur (500) est séparé du second conducteur supérieur (508) et le premier conducteur supérieur (544) est séparé du second conducteur inférieur (552) par une couche isolante.

3. Circuit selon la revendication 1 ou la revendication 2, comprenant en outre un troisième conducteur (536) couplé au premier conducteur inférieur (500), et un quatrième conducteur (580) couplé au second conducteur inférieur (522).

4. Circuit selon la revendication 3, dans lequel chacun des troisième et quatrième conducteurs (536,580) est connecté à une pluralité de cellules de mémoire (340,342, 344,346), chaque cellule de mémoire comprenant au moins un transistor MOS (426), le transistor MOS possédant une grille connectée à l'un des troisième et quatrième conducteurs respectifs.

5. Circuit selon la revendication 3 ou la revendication 4, dans lequel les troisième et quatrième conducteurs (536,580) comprennent des lignes de mots en silicium polycristallin, les lignes de mots en silicium polycristallin possédant un pas inférieur à l'espacement admissible entre des conducteurs inférieurs adjacents.

6. Circuit selon l'une quelconque des revendications 1 à 5, dans lequel le premier conducteur inférieur (500) et le premier conducteur supérieur (544) sont parallèles entre eux sur une partie substantielle de la longueur du premier conducteur supérieur (544), et le second conducteur supérieur (508) et le second conducteur inférieur (552) sont parallèles entre eux sur une partie substantielle de la longueur du second conducteur supérieur (552).

7. Circuit selon l'une quelconque des revendications 1 à 6, dans lequel le premier conducteur inférieur (500) est couplé au second conducteur supérieur (508) par un cinquième conducteur (516), et le premier conducteur (544) est couplé au second conducteur inférieur (552) par un sixième conducteur (560), les cinquième et sixième conducteurs étant formés de matériaux ayant des propriétés différentes de celles des premier et second conducteurs supérieurs.

8. Procédé pour former un circuit de câblage comprenant les étapes consistant à :
former une première pluralité de segments inférieurs de câblage (500,502,504) avec une orientation essentiellement linéaire;
former une seconde pluralité de segments inférieurs de câblage (552,554,556) avec une orientation essentiellement linéaire;
former une première pluralité de segments de câblage supérieurs (508,510), séparés desdits premiers segments de câblage inférieurs par une distance inférieure à un espacement admissible entre lesdits premiers et seconds câblages inférieurs, avec une orientation essentiellement linéaire, pour permettre la connexion électrique de la première pluralité de segments de câblage inférieurs; et
former une seconde pluralité de segments de câblage supérieurs (546,548) avec une orientation essentiellement linéaire, pour permettre de connecter électriquement la seconde pluralité de segments de câblage inférieurs.

9. Procédé selon la revendication 8, comprenant les étapes consistant à :
former la première pluralité de segments de câblage inférieurs (500,502,504) au voisinage de la première pluralité de segments de câblage supérieurs (508,510); et
former la seconde pluralité de segments de câblage inférieurs (552,554,556) au voisinage de la seconde pluralité de segments de câblage supérieurs (546,548).

10. Procédé selon la revendication 8 ou 9, comprenant les étapes consistant à :
former une première pluralité de segments de lignes de mots (536,538,540) connectés à des segments respectifs de la première pluralité de segments de câblage inférieurs (500,502,504); et
former une seconde pluralité de segments de lignes de mots (580,582,584) connectés à des segments respectifs de la seconde pluralité de segments de câblage inférieurs (552,554,556).
